# EUROPEAN PATENT APPLICATION

(11) **EP 4 597 129 A1**
(43) Date of publication of application: **06.08.2025**
(21) Application number: 23870962.0
(22) Date of filing: 27.09.2023
(51) Int. Cl.: G01R 31/28, G01R 31/26

(54) **TEST MACHINE, TEST SYSTEM, AND TEST METHOD**

(30) Priority: 29.09.2022 CN 202211198633
(71) Applicant: Beijing Huafeng Test & Control Technology Co., Ltd., Beijing 100094 (CN)
(72) Inventor: JU, Ning, Beijing 100094 (CN); ZHANG, Xiaotong, Beijing 100094 (CN)
(74) Representative: Stork Bamberger Patentanwälte PartmbB
(86) International application number: PCT/CN2023/122196
(87) International publication number: WO 2024/067735

(57) **Abstract**

The present disclosure relates to a tester, a test system, and a test method. The tester comprises a plurality of function boards, a main control module, and a co-processing module. The function boards implement different functions. The main control module is connected to the function boards and the host respectively and is configured to receive test item(s) sent by the host and send test sequences in the test item(s) to the function boards. The plurality of function boards is connected to at least one device under test, and is configured to send excitation signals to the at least one device under test according to the received test sequences, and receive response signals fed back by the at least one device under test based on the excitation signals, obtain test data, and send the test data to the co-processing module. The co-processing module is connected to the plurality of function boards respectively, and is configured to process the test data obtained by the function boards to obtain test result(s), and send them to the host. The present disclosure can improve the testing efficiency.

## Description

The present disclosure claims the priority benefit of Chinese Patent application No. 202211198633.9, named "TESTER, TEST SYSTEM AND TEST METHOD" and filed with the China National Intellectual Property Administration on September 29, 2022, the entire content of which is incorporated herein by reference.

### Technical Filed

The present disclosure relates to the field of testing technologies, and particularly to a tester, a test system and a test method.

### Background

An automatic test equipment (ATE) is an equipment for detecting the functional completeness of an integrated circuit (IC) in the semiconductor industry, and is applied to the final process of the production and manufacturing of the integrated circuit to ensure the quality of the production and manufacturing of the integrated circuit.

The ATE comprises a host, a tester and device(s) under test (DUT(s)). Test sequences are sent to the tester by the host. Excitation signals are generated according to the test sequences and sent to the device(s) under test by the tester. Response signals are fed back to the tester by the device(s) under test according to the excitation signals. Test data are obtained according to the response signals and sent to the host by the tester. The test data are processed to obtain test result(s) by the host for instructing a manipulator (handler) to classify the device(s) under test.

However, as the number of device under tests increases, the testing efficiency decreases.

### Summary

In view of the above-mentioned technical problems, there is a need to provide a tester, a test system, and a test method capable of improving the testing efficiency.

A first aspect of the present disclosure provides a tester. The tester comprises a plurality of function boards, a main control module, and a co-processing module;
the main control module is connected to the plurality of function boards and the host respectively, and is configured to receive test item(s) sent by the host and send test sequences in the test item(s) to the function boards;
the function boards are connected to at least one device under test, and is configured to send excitation signals to the at least one device under test according to the received test sequences, and receive response signals fed back by the at least one device under test based on the excitation signals, obtain test data, and send the test data to the co-processing module;
the co-processing module is connected to the function boards respectively, and is configured to process the test data obtained by the function boards to obtain test result(s), and send the test result(s)to the host.

In one embodiment, the co-processing module is configured to:
obtain expected data from the host and compare the expected data with the test data obtained by the function boards to obtain the test result(s).

In one embodiment, the co-processing module is configured to:
receive expected data sent by the main control module, wherein the expected data are sent by the host to the main control module.

In one embodiment, the co-processing module is configured to:
send the test result(s) to the main control module so that the main control module sends the test result(s) to the host.

In one embodiment, the main control module is configured to:
receive test configuration(s) sent by the host, wherein the test configuration(s) comprises channel numbers corresponding to the test sequences, channels to which the channel numbers belong are located between the function boards and test stations, and each of the test stations is configured to place one device under test; and
send each of the test sequences and the channel number corresponding to the test sequence to the function board corresponding to the channel number.

In one embodiment, each of the function boards comprises a controller and a functional circuit;
wherein the controller is connected to the main control module and the functional circuit of the same function board respectively, and is configured to receive test sequence(s) sent by the main control module and channel number(s) corresponding to the test sequence(s), control the functional circuit to generate excitation signal(s) according to the received test sequence(s), and send the excitation signal(s) generated by the functional circuit to device(s) under test placed at test station(s) corresponding to the channel number(s).

In one embodiment, the controller is further connected to the co-processing module, and is configured to receive response signal(s) fed back by the device(s) under test based on the excitation signal(s), obtain test data, and send the test data to the co-processing module.

In one embodiment, the function boards are configured to:
send the test data to the co-processing module when the test data are required to be processed, so that the co-processing module processes the test data to obtain the test result(s);
send the test data to the main control module when the test data are not required to be processed, so that the main control module sends the test data to the host; or
send the test data to the co-processing module and the main control module respectively, so that the co-processing module processes the test data that are required to be processed to obtain the test result(s), and the main control module sends the test data that are not required to be processed to the host.

In one embodiment, the tester further comprises:
a data interaction module connected to the function boards and a server respectively and configured to upload the test data obtained by the function boards to the server.

In one embodiment, the tester further comprises:
a clock module connected to the main control module and configured to provide clock signals; and
a calibration module connected to the clock module and the main control module respectively, and configured to provide calibration signals.

In one embodiment, the tester further comprises:
a system monitoring module connected to the function boards and the host respectively, and configured to monitor the function boards and feed back to the host.

A second aspect of the present disclosure provides a test system. The test system comprises a host and the tester provided in the first aspect.

A third aspect of the present disclosure provides a test method. The test method comprises:
receiving test item(s) sent by a host;
sending excitation signals to device(s) under test according to test sequences in the test item(s);
receiving response signals fed back by the device(s) under test based on the excitation signals to obtain test data; and
processing the test data to obtain test result(s) and sending the test result(s) to the host.

The above-mentioned tester, test system, and test method have the following advantages. The tester comprises a plurality of function boards, a main control module, and a co-processing module, and the function boards implement different functions. The main control module is connected to the plurality of function boards and the host respectively, and is configured to receive test item(s) from the host and send test sequences in the test item(s) to the function boards. The plurality of function boards is connected to at least one device under test, and is configured to send excitation signals to the at least one device under test according to the received test sequences and receive response signals from the at least one device under test to obtain test data, and send the test data to the co-processing module. The co-processing module is connected to the plurality of function boards respectively, and is configured to process the test data to obtain test result(s), and send them to the host. In this way, the test data is processed inside the tester. On the one hand, it can reduce the data processing amount of the host and the data processing time. On the other hand, it can shorten the feedback path of the test data and reduce the data transmission time. In summary, the testing efficiency is improved.

### Brief Description of the Drawings

The drawings used in the description of the embodiments or the prior art will be briefly introduced for the purpose of illustrating the embodiments of the present disclosure or the technical solutions in the prior art in a clear manner. It should be appreciated that the drawings in the description merely illustrate some embodiments of the present disclosure. Other drawings may be obtained according to the drawings without creative efforts for those skilled in the art.
FIG.1 is a structural schematic diagram of a tester according to an embodiment;
FIG.2 is a schematic diagram of information interaction during the testing in the prior art;
FIG.3 is a schematic diagram of information interaction during the testing according to an embodiment;
FIG.4 is a flow chart of a test method according to an embodiment;

### Description of the reference signs:

10: function board; 11: controller; 12: functional circuit;
20: main control module;
30: co-processing module;
40: data interaction module;
50: clock module;
60: calibration module;
70: system monitoring module;
100: host; 200: device under test (DUT) ; 210: load board; 300: server; 400: tester.

### Detailed Description

In order to facilitate an understanding of the present disclosure, the present disclosure will be described in details hereinafter with reference to the accompanying drawings. Embodiments of the present disclosure are shown in the accompanying drawings. This present disclosure may, however, be implemented in many different forms and should not be limited to the embodiments set forth herein. Rather, these embodiments are provided so that the present disclosure may be thorough and comprehensive

Unless defined otherwise, all technical and scientific terms used herein have the same meaning as commonly understood by those skilled in the art to which the present disclosure belongs. The terms used in the description of the present disclosure herein is used for the purpose of describing particular embodiments only and is not intended to limit the present disclosure.

It should be appreciated that, as used herein, the terms "first," "second," and the like may be used to describe various elements, but these elements should not be limited by these terms. These terms are merely used to distinguish one element from another.

Spatial relation terms, such as "under", "below", "beneath", "above", "on top of", and the like, can be used herein to describe the relation between one element or feature and other elements or features shown in the figure. It should be appreciated that in addition to the orientation shown in the figure, spatial relation terms also comprise different orientations of the device during use and operation. For instance, if the device in the figure is flipped, an element or feature described as "under" or "beneath" or "below" other elements or features will be oriented "above" other elements or features. Therefore, the exemplary terms "under" and "below" can comprise both upward and downward orientations. In addition, the device can also have other orientations (such as rotating 90 degrees or other orientations), and the spatial relation used herein are correspondingly derived.

It should be appreciated that, when a component is regarded as being "connected" to other component, it can be linked to the other component directly or via an intermediate component. In addition, "connected" in the following embodiments is to be understood as "electrically connected", " communicatively connected", and the like if the connected circuits, modules, units, and the like have communication of electrical signals or data with each other.

As used herein, the singular forms of the terms "a", "an" and "the" may comprise the plural forms as well, unless the context clearly indicates otherwise. It should be further appreciated that the terms "comprises/comprising", "having", and the like, specify the presence of defined features, integers, steps, operations, components, parts, or combinations thereof, but do not preclude the presence or addition of one or more other features, integers, steps, operations, components, parts, or combinations thereof. Also, as used in the description, the term "and/or" comprises any and all combinations of the associated listed items.

As described in the background art, there is a problem in the prior art that the test systems have low testing efficiency. According to the research of the inventor, the reason for this problem is in that, the existing testers comprise a main control module and at least one function board (instrument). The host sends test sequences to the main control module. The main control module forwards the test sequences to the function boards. The function boards generate excitation signals according to the received test sequences and sends them to the device(s) under test. The device(s) under test feed(s) back response signals to the function boards based on the excitation signals. The function boards obtain test data from the response signals and sends them to the main control module. The main control module forwards the test data to the host. The host processes the test data (such as comparing the data results with preset values) to obtain test results.

Wherein, the test data obtained by the function boards are forwarded to the host via the main control module, and are processed by the host. Since the test results of one device under test are obtained based on several test data, as the number of devices under test increases, the amount of test data increases significantly. Further, because all the test data should be forwarded to the host via the main control module to be processed by the host to obtain the test results, a large amount of test data will cause blocking in the transmission channels, and the transmission time of the entire test data is long, which seriously affects the testing efficiency. Moreover, since all the test results are obtained by the host which processes the test data, a large amount of test data forms blocking in the host, and the processing time of the entire test data is long, which further reduces the testing efficiency.

For the above-mentioned reasons, the present disclosure provides a tester, a test system, and a test method. By adding a co-processing module in the tester, the test data obtained by the function boards can be processed in the tester and the obtained test results then can be sent to the host. In this way, the test results can be obtained in the tester in advance, which can shorten the feedback path of the test data. The tester now sends the test results to the host instead of sending test data. Since the data volume of the test results is much smaller than that of the test data, the data transmission time between the tester and the host is greatly reduced, thereby improving the testing efficiency. Moreover, the test data for multiple testers are processed inside respective testers, which can avoid the situation where the test data for the multiple testers are all processed on the same host, thereby reducing the processing time of the test data and further improving the testing efficiency.

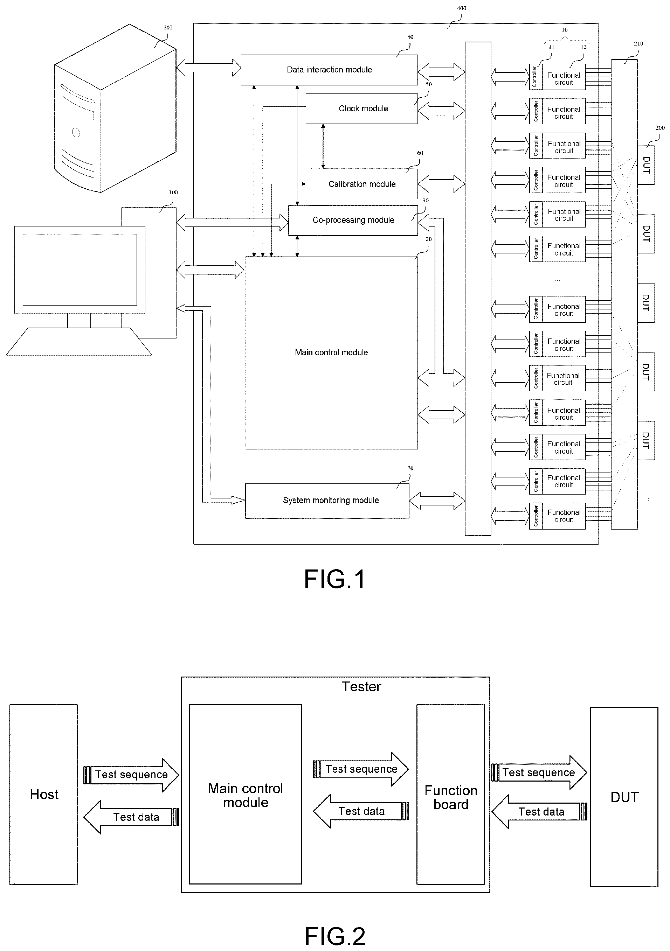

In one embodiment, as shown in FIG.1, a tester is provided, which comprises a plurality of function boards 10, a main control module 20, and a co-processing module 30. The function boards 10 implement different functions. The main control module 20 is connected to the plurality of function boards 10 and the host 100 respectively, and is configured to receive test item(s) sent by the host 100 and send test sequences in the test item(s) to the corresponding function boards 10. The plurality of function boards 10 are connected to at least one device under test 200, and are configured to send excitation signals to the at least one device under test 200 according to the received test sequences, receive response signals fed back by the at least one device under test 200 based on the excitation signals, obtain test data, and send the test data to the co-processing module 30. The co-processing module 30 is connected to the plurality of function boards 10 respectively, and is configured to process the test data obtained by the function boards 10, obtain test result(s), and send them to the host 100.

Wherein, the function boards 10 are circuit boards for testing. In practical applications, the plurality of function boards 10 can be integrated together, that is, the circuits for different functions of the plurality of function boards 10 are distributed on the same board. The plurality of function boards 10 may be independent of each other, that is, the circuits for different functions of the plurality of function boards 10 are distributed on different boards. For example, the circuit for one function is distributed on one board to form a circuit board, and the circuit for another function is distributed on another board to form another circuit board.

Both the main control module 20 and the co-processing module 30 may be processors. In practical applications, the main control module 20 and the co-processing module 30 may be implemented by the same processor or different processors. The number of processors for implementing the main control module 20 or the co-processing module 30 may be one or more.

Specifically, the host 100 sends test item(s) to the main control module 20. One test item comprises multiple test sequences. The main control module 20 sends each of the test sequences in the test item(s) to corresponding one of the function boards 10, wherein the function board 10 corresponding to each test sequence can be determined according to at least one of the functions to be realized by the test sequence, whether or not the function board 10 is occupied, and the sending time of the test sequence. The function boards 10 send excitation signals to the at least one device under test 200 according to the received test sequences. The at least one device under test 200 feeds back response signals based on the received excitation signals. The function boards 10 obtain test data from the received response signals and send the test data to the co-processing module 30. The co-processing module 30 processes the test data obtained from the function boards 10 to obtain test result(s), and sends the test result(s) to the host 100. In practical applications, the co-processing module 30 may directly send the test result(s) to the host 100, or send the test result(s) to the main control module 20 that then sends the test result(s) to the host 100.

Exemplarily, the co-processing module 30 is configured to send the test result(s) to the main control module 20 so that the main control module 20 sends the test result(s) to the host 100.

FIG.2 is a schematic diagram of information interaction during the testing in the prior art. As shown in FIG.2, the test sequences are sent from a host to a main control module in a tester, then from the main control module to function boards in the tester, and finally from the function boards to device(s) under test to start the testing. The test data obtained upon completing of the testing are sent from the device(s) under test to the function boards, then from the function boards to the main control module, and finally from the main control module to the host.

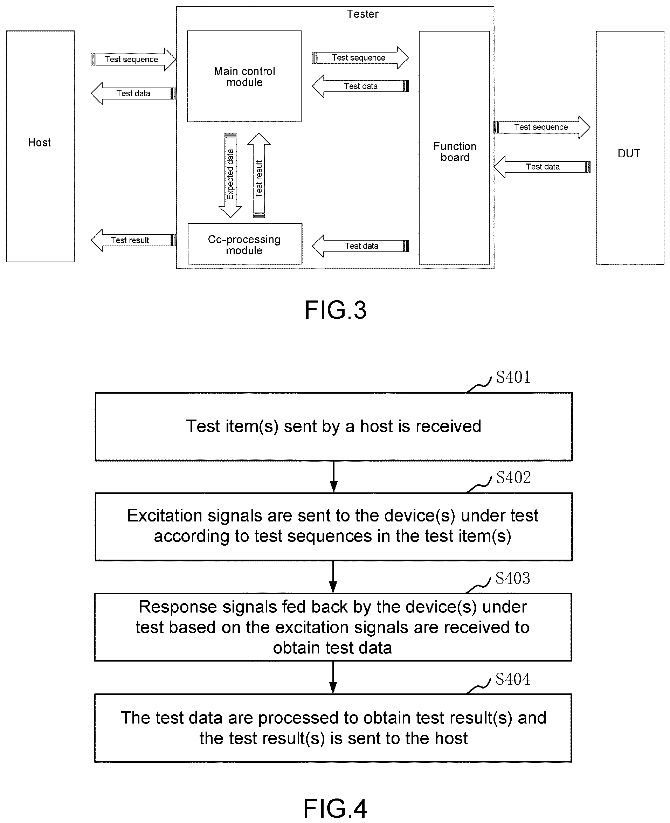

FIG.3 is a schematic diagram of information interaction during the testing according to one embodiment. As shown in FIG.3, the test sequences are also sent from a host to a main control module in a tester, then from the main control module to function boards in the tester, and finally from the function boards to device(s) under test to start the testing. The present disclosure is different from the prior art in that, after the test data obtained upon completing of the testing are sent from the device(s) under test to the function boards, the function boards send the test data to the main control module and a co-processing module in the tester respectively. The main control module still sends the test data to the host. The co-processing module processes the test data according to expected data sent by the main control module to obtain test result(s), and sends the test result(s) to the main control module and the host respectively.

It can be seen that the present disclosure advances the processing of the test data from the host to the tester, thereby shortening the feedback path of the test data and reducing the data transmission time. Moreover, processing of the test data by the tester can reduce the data processing volume of the host and shorten the data processing time.

The above-mentioned tester comprises a plurality of function boards, a main control module, and a co-processing module. The function boards implement different functions. The main control module is connected to the function boards and the host respectively, and is configured to receive test item(s) sent by the host and send test sequences in the test item(s) to the function boards. The plurality of function boards is connected to at least one device under test, and is configured to send excitation signals to the at least one device under test according to the received test sequences, receive the response signals fed back by the at least one device under test based on the excitation signals, obtain test data, and send the test data to the co-processing module. The co-processing module is connected to the plurality of function boards respectively, and is configured to process the test data obtained by the function boards to obtain test result(s), and send the test result(s) to the host. In this way, the test data are processed inside the tester. On the one hand, it can reduce the data processing volume of the host and shorten the data processing time. On the other hand, it can shorten the feedback path of the test data and reduce the data transmission time. In summary, the test efficiency is improved.

Exemplarily, the function boards 10 may be dedicated function boards. In this case, one function board can complete the testing of one device under test. The function boards 10 may also be general-purpose function boards. In this case, the function boards work together to complete the testing of one device under test. Different function boards may be combined for testing according to different devices under test. For example, the plurality of function boards comprises four function boards, namely a first function board, a second function board, a third function board, and a fourth function board. The four function boards implement different functions, wherein the first function board is a power supply board, the second function board is a digital circuit board, the third function board is a signal source board, and the fourth function board is an oscilloscope board.

In one embodiment, the co-processing module 30 is configured to obtain expected data from the host 100 and compare the expected data with the test data obtained by the function boards 10 to obtain the test result(s).

Wherein, the expected data is data for determining whether the testing passes.

Exemplarily, the co-processing module 30 is configured to receive expected data sent by the main control module 20, wherein the expected data is sent by the host 100 to the main control module 20.

Specifically, the expected data may be sent directly from the host 100 to the co-processing module 30, or it may be sent from the host 100 to the main control module 20 and then from the main control module 20 to the co-processing module 30. The expected data are compared with the test data obtained by the function boards 10. For example, if the test data obtained by the function boards 10 are greater than or equal to the expected data, it is determined that the testing passes; if the test data obtained by the function boards 10 are less than the expected data, it is determined that the testing fails. Alternatively, if the test data obtained by the function boards 10 are less than or equal to the expected data, it is determined that the testing passes; if the test data obtained by the function boards 10 are greater than the expected data, it is determined that the testing fails.

In the above-mentioned embodiment, by obtaining the expected data from the host, the co-processing module can replace the host to process the test data, such as comparing the expected data with the test data obtained by the function boards to obtain the test result(s).

In one embodiment, the main control module 20 is configured to: receive test configuration(s) sent by the host 100, wherein he test configuration(s) comprises channel numbers corresponding to the test sequences, channels to which the channel numbers belong are located between the function boards 10 and test stations, and each of the test stations is configured to place one device under test 200; and send each of the test sequences and the channel number corresponding to the test sequence to the function board 10 corresponding to the channel number.
wherein, the test configuration(s) is used to control the sending of each of the test sequences in the test item(s).

Specifically, the host 100 sends the test item(s) and the test configuration(s) to the main control module 20 together. The main control module 20 obtains the channel numbers corresponding to the test sequences in the test item(s) from the test configuration(s). The channels to which the channel numbers belong are located between the function boards 10 and the test stations. The test stations are configured to place the at least one device under test 200. One channel number can match the corresponding test sequence with both the corresponding function board 10 and the corresponding device under test 200, thereby allowing the main control module 20 to send each test sequence to the function board 10 corresponding to the channel number corresponding to the test sequence, and then allowing the function board 10 to send the excitation signal generated according to the test sequence to the test station corresponding to the channel number, that is, the device under test 200.

Exemplarily, as shown in FIG.1, a load board 210 is provided. The load board is provided with multiple test stations thereon, at which the at least one device under test 200 is placed.

In one embodiment, as shown in FIG.1, each of the function boards 10 comprises a controller 11 and a functional circuit 12. The controller 11 is connected to the main control module 20 and the functional circuit 12 of the same function board 10 respectively, and is configured to receive test sequence(s) and channel number(s) corresponding to the test sequence(s) sent by the main control module 20, control the functional circuit 12 to generate excitation signal(s) according to the received test sequence(s), and send the excitation signal(s) generated by the functional circuit 12 to device(s) under test 200 placed at test station(s) corresponding to the channel number(s).

Wherein, the controller 11 realizes the information interaction between the function board 10 and the outside (including other function boards 10), and the functional circuit 12 realizes the function of the function board 10. In practical applications, the controller 11 may comprise a processor and a communication interface.

Specifically, the main control module 20 sends the test sequence(s) and the channel number(s) to the controller 11 together. The controller 11 controls the functional circuit 12 to generate corresponding excitation signal(s) according to the test sequence(s) and sends the excitation signal(s) to the device(s) under test 200 placed at the test station(s) corresponding to the channel number(s).

In the above-mentioned embodiment, the main control module is provided with a controller therein, which can realize the information interaction between the function boards and the outside.

In one embodiment, the controller 11 is further connected to the co-processing module 30, and is configured to receive response signal(s) fed back by the device(s) under test 200 based on the excitation signal(s), obtain test data, and send the test data to the co-processing module 30.

In one embodiment, the function boards 10 are configured to send the test data to the co-processing module 30 when the test data is required to be processed , so that the co-processing module 30 processes the test data to obtain the test result(s).

In one embodiment, the function board 10 is further configured to send the test data to the main control module 20 when the test data is not required to be processed, so that the main control module 20 sends the test data to the host 100.

Specifically, some test data are required to be processed, such as being compared with the expected data, while some are not required to be processed. The controller 11 sends the test data that are required to be processed to the co-processing module 30 for processing, obtains the test result(s) and sends them to the host 100, and sends the test data that are not required to be processed to the main control module 20 that directly sends the test data to the host 100.

In one embodiment, the function board 10 is configure to send the test data to the main control module 20 and the co-processing module 30 respectively, so that the main control module 20 sends the test data that are not required to be processed to the host 100, and the co-processing module 30 processes the test data that are required to be processed to obtain the test result(s).

In one embodiment, as shown in FIG. 1, the tester further comprises a data interaction module 40. The data interaction module 40 is respectively connected to the plurality of function boards 10 and a server 300, and is configured to upload the test data obtained by the function boards 10 to the server 300.

Wherein, the data interaction module 40 is a processor. In practical applications, the main control module 20, the co-processing module 30, and the data interaction module 40 may be implemented by the same processor or by different processors. The number of processors for implementing the data interaction module 40 may be one or more.

Specifically, in addition to sending the test data to the main control module 20 or the co-processing module 30, the function boards 10 further send the test data to the data interaction module 40. The data interaction module 40 uploads the test data to the server 300.

In the above-mentioned embodiment, by adding the data interaction module, the test data can be uploaded to the server for easy query.

Exemplarily, the data interaction module 40 is further connected to the main control module 20 and the co-processing module 30 respectively, and is configured to monitor the main control module 20 and the co-processing module 30.

In the above-mentioned embodiment, the data interaction module can further monitor the operating conditions of the main control module and the co-processing module in real time.

In one embodiment, as shown in FIG.1, the tester further comprises a clock module 50. The clock module 50 is connected to the main control module 20 and is configured to provide clock signals.

Exemplarily, the clock module 50 is further connected to the function boards 10.

In the above-mentioned embodiment, by adding the clock module, the clock signals are provided inside the tester.

In one embodiment, as shown in FIG.1, the tester further comprises a calibration module 60. The calibration module 60 is connected to the clock module 50 and the main control module 20 respectively, and is configured to provide calibration signals.

Exemplarily, the calibration module 60 is further connected to the function boards 10.

In the above-mentioned embodiment, by adding the calibration module, clock calibration is performed inside the tester.

In one embodiment, as shown in FIG.1, the tester further comprises a system monitoring module 70. The system monitoring module 70 is connected to the plurality of function boards 10 and the host 100 respectively, and is configured to monitor the function boards 10 and feed back to the host 100.

In the above-mentioned embodiment, by adding the system monitoring module, the operating status of the function boards can be monitored, which is beneficial for timely alarming or handling when any of the function boards is abnormal.

Based on the same inventive concept, a test system is also provided. As shown in FIG.1, the test system comprises a host 100 and the tester 400 provided in any of the above-mentioned embodiments.

Based on the same inventive concept, a test method is also provided. As shown in FIG.4, it comprises the following steps.

In a step S401, test item(s) sent by the host is received.

Specifically, the tester comprises the main control module, wherein the main control module receives the test item(s) sent by the host.

In practical applications, the host, on the one hand, receives a confirmation signal for a work mode input by the user, and on the other hand, loads a user program, wherein the work mode includes a software and hardware debugging mode and a mass production mode, and the user program includes test configuration(s) and test item(s). Then the host verifies the hardware configuration in the tester and the software configuration in the user program, and confirms the test configuration(s), such as specifying the number of stations, station numbers, and external devices. Then the tester loads the test configuration(s) and part of the test sequences and waits for a Start of Test (SOT) signal. After the testing starts, the tester starts to test the device(s) under test. In addition, the tester sends an End of Test (EOT) signal to the host, and the host controls the manipulator to replace the device(s) under test.

In a step S402, excitation signals are sent to the device(s) under test according to test sequences in the test item(s).

Specifically, the tester further comprises the plurality of function boards. The main control module sends each of the test sequences in the test item(s) to the corresponding function board. The function boards generate excitation signals according to the received test sequences and send them to the device(s) under test.

In a step S403, response signals fed back by the device(s) under test based on the excitation signals are received to obtain test data.

Specifically, the function boards receive the response signals fed back by the device(s) under test based on the excitation signals to obtain test data.

In a step S404, the test data are processed to obtain the test result(s), and the test result(s) is sent to the host.

Specifically, the tester further comprises the co-processing module. The function boards send the test data to the co-processing module. The co-processing module processes the test data to obtain the test result(s), and sends the test result(s) to the host.

In the disclosure herein, terms such as "some embodiments," "other embodiments," "preferred embodiments," or the like, are intended that a particular feature, structure, material, or characteristic described in connection with the embodiment or example is comprised in at least one embodiment or example of the disclosure. In the disclosure, schematic depictions of the above terms do not necessarily refer to the same embodiment or example.

The technical features of the above embodiments may be combined at random. All possible combinations of the technical features of the above embodiments may not be described for the sake of brevity, but should be considered as within the scope of the present disclosure as long as there is no contradiction between the combinations of the technical features.

The above-mentioned embodiments are merely schematic several embodiments of the present disclosure. The description of the embodiments is specific and detailed, but it should not be understood as limitation on the scope of the disclosure. It should be noted that various changes and modifications can be made by those skilled in the art without departing from the spirit of the disclosure, and these changes and modifications are all within the scope of the disclosure. Therefore, the protection scope of the present patent should be subject to the appended claims.

## Claims

1. A tester, **characterized in that** the tester comprises a plurality of function boards, a main control module, and a co-processing module;
wherein the main control module is connected to the function boards and the host respectively, and is configured to receive test item(s) sent by the host and send test sequences in the test item(s) to the function boards;
the function boards are connected to at least one device under test, and are configured to send excitation signals to the at least one device under test according to the received test sequences, and receive response signals fed back by the at least one device under test based on the excitation signals, obtain test data, and send the test data to the co-processing module;
the co-processing module is connected to the function boards respectively, and is configured to process the test data obtained by the function boards to obtain test result(s), and send the test result(s) to the host.

2. The tester according to claim 1, **characterized in that** the co-processing module is configured to obtain expected data from the host and compare the expected data with the test data obtained by the function boards to obtain the test result(s).

3. The tester according to claim 2, **characterized in that** the co-processing module is configured to receive expected data sent by the main control module, wherein the expected data are sent by the host to the main control module.

4. The tester according to claim 1, **characterized in that** the co-processing module is configured to send the test result(s) to the main control module so that the main control module sends the test result(s) to the host.

5. The tester according to claim 1, **characterized in that** the main control module is configured to:
receive test configuration(s) sent by the host, wherein the test configuration(s) comprises channel numbers corresponding to the test sequences, channels to which the channel numbers belong are located between the function boards and test stations, and each of the test stations is configured to place one device under test; and
send each of the test sequences and the channel number corresponding to the test sequence to the function board corresponding to the channel number.

6. The tester according to claim 5, **characterized in that** each of the function boards comprises a controller and a functional circuit,
wherein the controller is connected to the main control module and the functional circuit of the same function board respectively, and is configured to receive test sequence(s) sent by the main control module and channel number(s) corresponding to the test sequence(s), control the functional circuit to generate excitation signal(s) according to the received test sequence(s), and send the excitation signal(s) generated by the functional circuit to device(s) under test placed at test station(s) corresponding to the channel number(s).

7. The tester according to claim 6, **characterized in that** the controller is further connected to the co-processing module, and is configured to receive response signal(s) fed back by the device(s) under test based on the excitation signal(s), obtain test data, and send the test data to the co-processing module.

8. The tester according to any one of claims 1-7, **characterized in that** the function boards are configured to:
send the test data to the co-processing module when the test data are required to be processed, so that the co-processing module processes the test data to obtain the test result(s);
send the test data to the main control module when the test data are not required to be processed, so that the main control module sends the test data to the host; or
send the test data to the co-processing module and the main control module respectively, so that the co-processing module processes the test data that are required to be processed to obtain the test result(s), and the main control module sends the test data that are not required to be processed to the host.

9. The tester according to any one of claims 1-7, **characterized in that** the tester further comprises a data interaction module connected to the function boards and a server respectively and configured to upload the test data obtained by the function boards to the server.

10. The tester according to any one of claims 1-7, **characterized in that** the tester further comprises:
a clock module connected to the main control module and configured to provide clock signals; and
a calibration module connected to the clock module and the main control module respectively, and configured to provide calibration signals.

11. The tester according to any one of claims 1-7, **characterized in that** the tester further comprises a system monitoring module connected to the function boards and the host respectively, and configured to monitor the function boards and feed back to the host.

12. A test system, **characterized in that** the test system comprises a host and the tester according to any one of claims 1-11.

13. A test method, **characterized in that** the method comprises:
receiving test item(s) sent by a host;
sending excitation signals to device(s) under test according to test sequences in the test item(s);
receiving response signals fed back by the device(s) under test based on the excitation signals to obtain test data; and
processing the test data to obtain test result(s) and sending the test result(s) to the host.
